# FASCICULE DE BREVET EUROPEEN

(11) **EP 2 143 309 B1**
(45) Date de publication et mention de la délivrance du brevet: **08.12.2010**
(21) Numéro de dépôt: 08736542.5
(22) Date de dépôt: 24.04.2008
(51) Int. Cl.: H05K 1/16, H01F 41/04

(54) **PROCEDE DE REALISATION D'UN MODULE D'ALIMENTATION A BASE DE MATERIAU MAGNETIQUE**
VERFAHREN ZUR HERSTELLUNG EINES AUF EINEM MAGNETISCHEN MATERIAL BASIERENDEN ZUFUHRMODULS
METHOD FOR MAKING A SUPPLY MODULE BASED ON MAGNETIC MATERIAL

(30) Priorité: 04.05.2007 FR 0703245
(43) Date de publication de la demande: 13.01.2010
(73) Titulaire: THALES, 92200 Neuilly-sur-Seine (FR)
(72) Inventeur: THOMAS, Philippe, 94150 Rungis (FR)
(74) Mandataire: Esselin, Sophie
(86) Numéro de dépôt international: PCT/EP2008/055007
(87) Numéro de publication internationale: WO 2008/135400

(56) Documents cités:
- WO-A-2006/122195
- US-A1- 2004 145 445
- US-B1- 6 996 892

## Description

L'invention se rapporte à des modules électriques à haut niveau d'intégration à base de matériau magnétique.

Actuellement, le développement des matériels électroniques, tant dans les applications civiles que militaires, est lié à la miniaturisation des composants passifs et actifs. Parmi ces composants, les plus volumineux sont les composants passifs qui réalisent les fonctions résistance, capacité, inductance ou transformateur, et plus particulièrement les composants passifs inductifs (inductance ou transformateur). Ces composants sont réalisés à partir d'un noyau magnétique en matériau magnétique et d'un ou plusieurs bobinages, le plus souvent en fil de cuivre, qui peuvent être intégrés dans un circuit imprimé.

US 6 996 892, WO 2006/122 195 et US 2004/145 445 représentent des exemples de l'art antérieur.

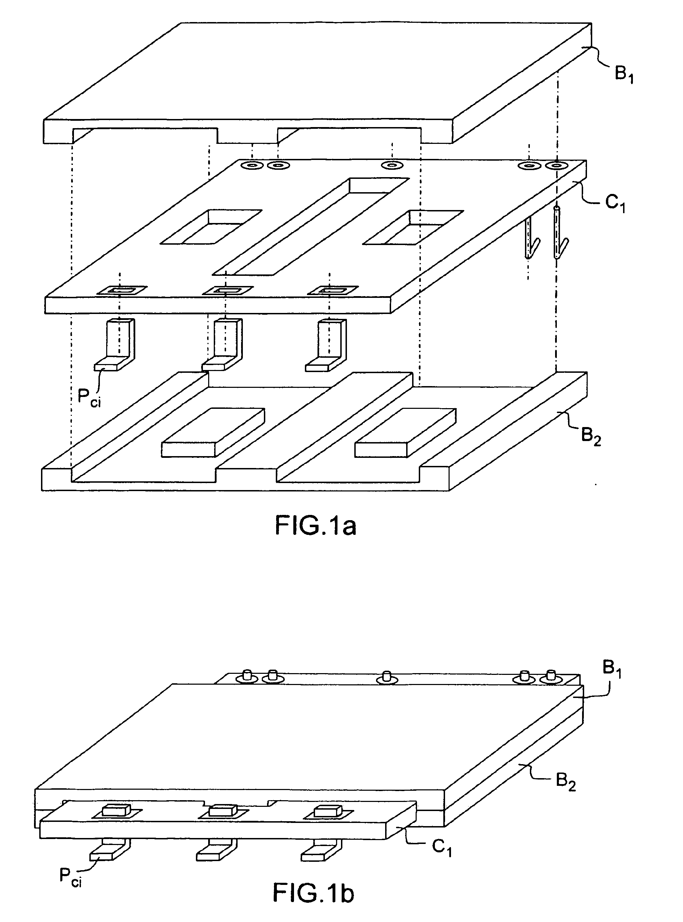

Il est connu de les réaliser par une technologie dite « planar » dans laquelle deux pièces de matériau magnétique B₁ et B₂ sont rapportées de part et d'autre d'un circuit imprimé C₁ généralement composé de multi-couches ou d'un stratifié , comme illustré en figure 1a qui monstre une vue éclatée d'un tel module. Des pattes de contact p_{ci}, situées en périphérie permettent de venir reporter le module d'alimentation sur un circuit comportant des composants et sont mises en évidence sur la figure 1 b.

Dans ce contexte et afin de réaliser des composants de faibles dimensions la présente invention propose une architecture de module compact dont le report sur une carte électronique est rendu plus facile. Ce type de module peut être un module d'alimentation dans le domaine de l'électronique de puissance ou tout autre module présentant une topologie ne nécessitant pas de matériau avec une forte perméabilité.

L'invention a pour objet un procédé de réalisation d'un module d'alimentation **caractérisé en ce qu**'il comporte les étapes suivantes :
- l'assemblage d'un circuit imprimé intermédiaire comprenant des ouvertures centrales et un bobinage en périphérie desdites ouvertures centrales, avec un premier et un second gabarits en matériau diélectrique présentant des ouvertures centrales de plus grande dimensions que les ouvertures centrales du circuit imprimé intermédiaire ;
- le remplissage des ouvertures des gabarits et des ouvertures centrales du circuit intermédiaire par un matériau magnétique.

Selon une variante de l'invention, le matériau magnétique comporte un liant et des particules de ferrite.

Avantageusement, le liant est un monomère et le procédé comprend une étape de polymérisation pour polymériser le matériau magnétique.

Selon une variante de l'invention, le procédé de réalisation comprend l'assemblage de l'ensemble constitué par les deux gabarits et le circuit imprimé intermédiaire avec un circuit imprimé annexe .

Selon une variante de l'invention, le procédé de réalisation comporte le report de composants sur une face dite externe du circuit imprimé annexe.

Selon une variante de l'invention, le procédé comprend la réalisation de vias conducteurs au travers des deux gabarits et du circuit imprimé annexe de manière à pouvoir connecter électriquement l'ensemble réalisé, à une carte électronique.

L'invention sera mieux comprise et d'autres avantages apparaîtront à la lecture de la description qui va suivre donnée à titre non limitatif et grâce aux figures annexées parmi lesquelles :
- la figure 1a illustre une vue éclatée, d'un module électrique en technologie planaire selon l'art connu et la figure 1b illustre le module alimentation complet ;
- la figure 2 illustre une vue éclatée de l'empilement de trois circuits imprimés permettant d'élaborer un module d'aimantation selon la présente invention ;
- la figure 3 illustre le remplissage des deux gabarits constitués par deux circuits imprimés par un matériau magnétique ;
- la figure 4 illustre le report de l'ensemble préconstitué et illustré en figure 3, sur un circuit imprimé annexe;
- les figures 5a et 5b illustrent deux vues en coupe mettant en évidence le montage de composants sur l'ensemble réalisé et illustré en figure 4 ;
- la figure 6 illustre le report du module d'alimentation selon l'invention sur une carte électronique.

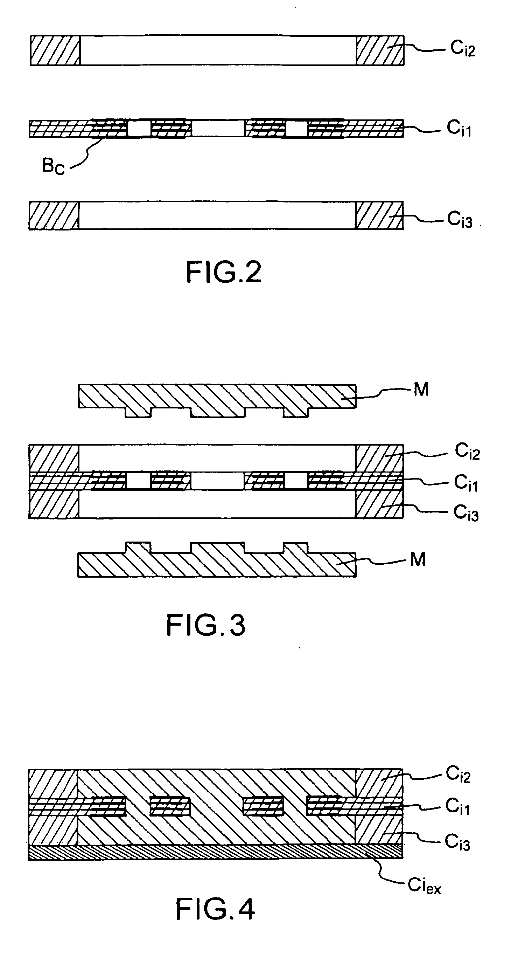

De manière générale le module d'alimentation selon l'invention est réalisé selon les étapes décrites ci-après :
A partir d'un substrat diélectrique de type circuit imprimé dit intermédiaire Cᵢ₁, on réalise, de manière classique, au moins un bobinage en matériau conducteur Bc pouvant typiquement être du cuivre et au moins une ouverture centrale destinée à être remplie de matériau magnétique. On procède ensuite à l'empilement de deux éléments appelés gabarit de part et d'autre dudit circuit imprimé intermédiaire Cᵢ₂ et Cᵢ₃. Ces éléments sont typiquement des substrats diélectriques perforés en leur partie centrale de manière à présenter des ouvertures de taille supérieure à la taille de l'ouverture centrale du circuit imprimé intermédiaire. La figure 2 illustre un tel empilement

Dans une seconde étape, après empilement et assemblage pouvant être réalisé par pressage (ou stratification ), les deux gabarits sont remplis de matériau magnétique M de manière à constituer le circuit magnétique des composant inductifs (transformateur ou inductance) comme illustré en figure 3. Cette figure schématise l'introduction du matériau magnétique au sein des ouvertures des gabarits Cᵢ₂ et Cᵢ₃.

Selon une variante de l'invention, le matériau magnétique peut être un matériau composite comportant un liant et de la poudre ferromagnétique de type poudre de fer par exemple. Plus précisément il peut s'agir d'un précurseur de résine époxy au sein duquel sont dispersées des particules de fer.

Avantageusement les particules de fer sont des particules nanocristallines. La fabrication de telles particules est notamment décrite dans l'article « Analysis of the initial complex permeability versus frequency of soft nano-crystalline ribbons and derived composites » de R. Le bourgeois, S. Béreneguer, C. Ramiarinjaona et T. Waeckerle, Journal of Magnetism and Magnetic Materials Published by Elsevier Science B. V.

Il s'agit de ruban de poudre de ferrite obtenue à partir de ruban de fer amorphe et porté à haute température, typiquement à 540°C sous atmosphère inerte. Après broyage ces particules de nanostructure cristalline peuvent être dispersées dans un précurseur de liant, capable de polymériser. La caractéristique remarquable d'un matériau nanocristallin est sa structure à deux phases où une structure cristalline fine (diamètre moyen de grains de 10 à 20 nm) est enveloppée dans une phase résiduelle amorphe. Cette double structure est responsable du fait que ces matériaux peuvent atteindre les perméabilités les plus élevées et les champs coercitifs les plus faibles. De plus leur faible épaisseur de bande (environ 20µm) et leur résistance électrique relativement importante leur procure de très faibles pertes par courant de Foucault et une excellente tenue en fréquence et en perméabilité, alliées à une saturation de leur densité de flux de 1.2 Tesla et à des propriétés thermiques favorables.

Dans une troisième étape, on procède à la polymérisation du précurseur typiquement par chauffage de manière à densifier et ainsi solidifier le matériau composite, au sein des ouvertures des gabarits et de l'ouverture centrale du circuit imprimé intermédiaire pour ainsi constituer les noyaux magnétiques au sein du composant.

Dans une quatrième étape, suite à la polymérisation, on presse un ou deux circuits imprimés Ciₑₓ sur les faces extérieures de l'empilement (ou sur les deux) comme représenté en figure 4, destinés à assurer les connexions avec des composants ultérieurement montés dessus. Il est à noter que ce ou ces circuits imprimés peuvent être constitués de plusieurs couches

Selon une cinquième étape, on vient reporter des composants actifs ou passifs Cₒᵢ sur une face externe du circuit ou des circuits annexes.

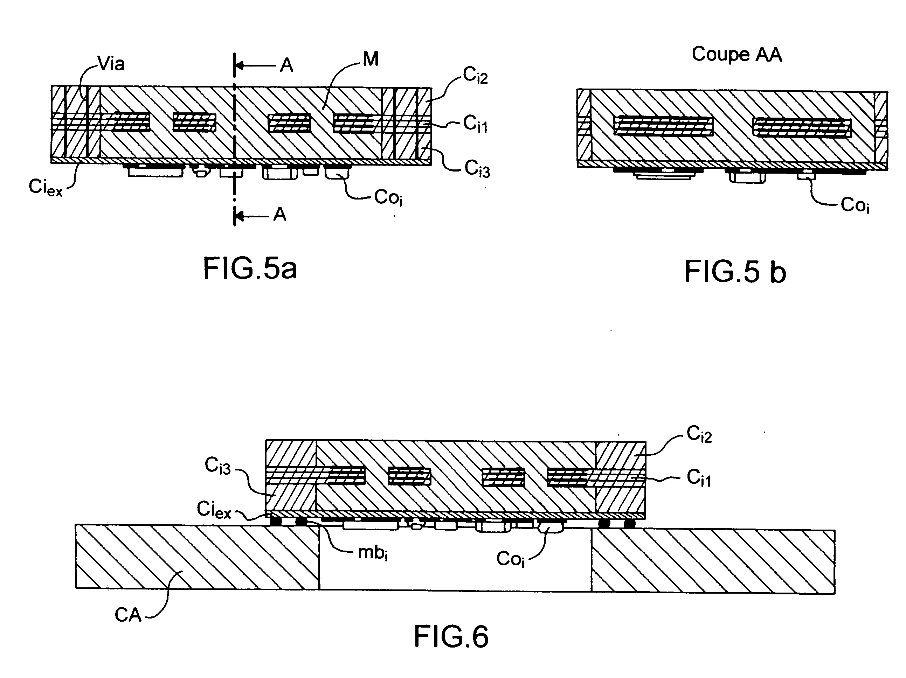

Ainsi on réalise des bobinages pouvant être connectés à des circuits extérieurs, au moyen de vias Vᵢₐ et des composants Cₒᵢ sont câblés sur l'un de ces circuits imprimés Ciₑₓ comme représentés en figure 5a et 5b qui représentent deux vues en coupe du module de puissance ainsi élaboré.

Selon une sixième étape, l'ensemble du module peut alors être monté sur une carte CA et interconnecté au moyen de lires, de picots ou de micro-billage m_{bi} comme illustré en figure 6.

## Revendications

1. Procédé de réalisation d'un module d'alimentation, **caractérisé en ce qu'**il comporte les étapes suivantes :
- l'assemblage d'un circuit imprimé intermédiaire (Cᵢ₁) comprenant des ouvertures centrales et un bobinage en périphérie des ouvertures centrales, avec un premier et un second gabarits en matériau diélectrique présentant des ouvertures centrales de plus grande dimensions que les ouvertures centrales du circuit imprimé intermédiaire ;
- le remplissage des ouvertures des gabarits et des ouvertures centrales du circuit intermédiaire par un matériau magnétique.

2. Procédé de réalisation d'un module d'alimentation selon la revendication 1, **caractérisé en ce que** le matériau magnétique comporte un liant et des particules de fer.

3. Procédé de réalisation d'un module d'alimentation selon la revendication 2, **caractérisé en ce que** le liant étant un monomère, il comprend une étape de polymérisation du matériau magnétique.

4. Procédé de réalisation d'un module d'alimentation selon l'une des revendications 2 à 3, **caractérisé en ce qu'**il comprend l'assemblage de l'ensemble constitué par les deux gabarits et le circuit imprimé intermédiaire avec un circuit imprimé annexe (Ciₑₓ).

5. Procédé de réalisation d'un module d'alimentation selon l'une des revendications 2 à 4, **caractérisé en ce qu'**il comporte le report de composants (Cₒᵢ) sur une face dite externe du circuit imprimé annexe.

6. Procédé de réalisation d'un module d'alimentation selon l'une des revendications 2 à 5, **caractérisé en ce qu'**il comprend la réalisation de vias (Vᵢₐ) conducteurs au travers des deux gabarits et du circuit imprimé annexe de manière à pouvoir connecter électriquement l'ensemble réalisé à une carte électronique.

## Claims

1. A process for producing a supply module, **characterised in that** it includes the following steps:
- assembling an intermediate printed circuit (Cᵢ₁) including central openings and a coil around the periphery of the central openings, with a first and a second plate made from dielectric material having central openings which are larger than the central openings of the intermediate printed circuit;
- filling the openings of the plates and the central openings of the intermediate circuit with a magnetic material.

2. The process for producing a supply module according to claim 1, **characterised in that** the magnetic material comprises a binder and iron particles.

3. The process for producing a supply module according to claim 2, **characterised in that** as the binder is a monomer, said process including a step of polymerisation of the magnetic material.

4. The process for producing a supply module according to any one of claims 2 to 3, **characterised in that** it includes the assembly of the set constituted by the two plates and the intermediate printed circuit with an additional printed circuit (Ciₑₓ).

5. The process for producing a supply module according to any one of claims 2 to 4, **characterised in that** it includes the transfer of components (Cₒᵢ) onto an external surface of the additional printed circuit.

6. The process for producing a supply module according to any one of claims 2 to 5, **characterised in that** it includes the production of conducting vias (Vᵢₐ) through the two plates and the additional printed circuit so as to be able to electrically connect the produced assembly to an electronic card.

## Patentansprüche

1. Verfahren zum Erzeugen eines Versorgungsmoduls, **dadurch gekennzeichnet, dass** es die folgenden Schritte beinhaltet:
- Montieren einer intermediären gedruckten Schaltung (Cᵢ₁) mit zentralen Öffnungen und einer Spule um die Peripherie der zentralen Öffnungen, mit einer ersten und einer zweiten Platte aus dielektrischem Material mit zentralen Öffnungen, die größer sind als die zentralen Öffnungen der intermediären gedruckten Schaltung;
- Füllen der Öffnungen der Platten und der zentralen Öffnungen der intermediären Schaltung mit einem magnetischen Material.

2. Verfahren zum Erzeugen eines Versorgungsmoduls nach Anspruch 1, **dadurch gekennzeichnet, dass** das magnetische Material ein Bindemittel und Eisenpartikel umfasst.

3. Verfahren zum Erzeugen eines Versorgungsmoduls nach Anspruch 2, **dadurch gekennzeichnet, dass** es, da das Bindemittel ein Monomer ist, einen Schritt des Polymerisierens des magnetischen Materials beinhaltet.

4. Verfahren zum Erzeugen eines Versorgungsmoduls nach einem der Ansprüche 2 bis 3, **dadurch gekennzeichnet, dass** es das Montieren des von den beiden Platten und der intermediären gedruckten Schaltung gebildeten Satzes mit einer zusätzlichen gedruckten Schaltung (Ciₑₓ) beinhaltet.

5. Verfahren zum Erzeugen eines Versorgungsmoduls nach einem der Ansprüche 2 bis 4, **dadurch gekennzeichnet, dass** es das Übertragen von Komponenten (Cₒᵢ) auf eine Außenfläche der zusätzlichen gedruckten Schaltung beinhaltet.

6. Verfahren zum Erzeugen eines Versorgungsmoduls nach einem der Ansprüche 2 bis 5, **dadurch gekennzeichnet, dass** es die Produktion von leitenden Durchkontaktierungen (Vᵢₐ) durch die beiden Platten und die zusätzliche gedruckte Schaltung beinhaltet, so dass die erzeugte Baugruppe mit einer elektronischen Karte elektrisch verbunden werden kann.
